**Europäisches Patentamt**

(19) **European Patent Office**

**Office européen des brevets**

(11) Numéro de publication: **0 129 470**
**B1**

## (12) FASCICULE DE BREVET EUROPÉEN

(45) Date de publication du fascicule du brevet:
**08.04.87**

(21) Numéro de dépôt: **84401205.4**

(22) Date de dépôt: **13.06.84**

(51) Int. Cl.⁴: **H 04 N 3/15**

(54) **Dispositif photosensible à l'état solide.**

(30) Priorité: **17.06.83 FR 8310067**

(43) Date de publication de la demande:
**27.12.84 Bulletin 84/52**

(45) Mention de la délivrance du brevet:
**08.04.87 Bulletin 87/15**

(84) Etats contractants désignés:
**DE GB**

(56) Documents cité:
**US-A-4 241 263**

**ELECTRONIQUE INDUSTRIELLE, no. 28, 15 février
1982 (PARIS, FR) F. BERNIER et al.: "Capteurs
optiques: les dispositifs photosensibles à transfert
de charge (DTC)", pages 63-67**

(73) Titulaire: **THOMSON- CSF, 173, Boulevard
Haussmann, F-75379 Paris Cedex 08 (FR)**

(72) Inventeur: **Portmann, Jacques, THOMSON- CSF
SCPI 173, bld Haussmann, F-75379 Paris Cedex 08
(FR)**
Inventeur: **Arques, Marc, THOMSON- CSF SCPI
173, bld Haussmann, F-75379 Paris Cedex 08 (FR)**

(74) Mandataire: **Ruellan- Lemonnier, Brigitte,
THOMSON- CSF SCPI 19, avenue de Messine,
F-75008 Paris (FR)**

## Description

La présente invention concerne les dispositifs photosensibles à l'état solide. Elle concerne plus particulièrement la partie lecture de ces dispositifs.

Les dispositifs photosensibles actuellement utilisés aussi bien dans le domaine du visible que de l'infrarouge sont constitués principalement par un ensemble de N photosenseurs connectés par l'intermédiaire d'une zone de transition à un registre à décalage à transfert de charge à N entrées parallèles et une sortie série. Le registre à décalage reçoit donc en entrée les charges détectées par les photosenseurs et les délivre en série vers un étage de lecture donnant en sortie un signal électrique d'analyse d'images.

L'utilisation d'un seul registre à décalage à transfert de charge dans la partie lecture du dispositif photosensible présente un certain nombre d'inconvénients.

En effet lorsque le nombre de photosenseurs, à savoir le nombre d'étages du registre à décalage est important, il en résulte un nombre de transfert important dans le registre à décalage et une fréquence des transferts élevée pour pouvoir réaliser la lecture en un temps donné. Ceci joue donc sur la consommation et la fréquence de fonctionnement de l'ensemble du circuit, ainsi que sur le bruit de transfert et la diaphonie due à l'inefficacité du transfert dans le registre à décalage.

La presente invention a donc pour but de remédier à ces inconvénients en divisant par deux le nombre des transferts ainsi que leur fréquence.

En conséquence, la présente invention a pour objet un dispositif photosensible à l'état solide pour la détection d'un rayonnement électromagnétique comportant N photosenseurs connectés par l'intermédiaire d'une zone de transition à un dispositif de lecture du type à transfert de charge caractérisé en ce que le dispositif de lecture est séparé en deux registres à décalage à transfert de charge contigus et alingés comprenant chacun $N/2$ entrées parallèles et une sortie série et recevant simultanément les charges détectées par les photosenseurs pour les transférer vers un étage de lecture unique positionné entre les deux registres, le transfert étant réalisé sous l'action de tensions de commande choisies de manière à lire alternativement chaque registre.

D'autres caractéristiques et avantages de la présente invention apparaîtront à la lecture de la description d'un mode de réalisation de l'invention faite avec référence aux dessins ci-annexés dans lesquels:

- la figure 1 est une vue de dessus schématique d'un dispositif photosensible de l'art antérieur,

- la figure 2 est une vue de dessus schématique d'un dispositif photosensible conforme à la présente invention,

- les figures 3(a) à (c) représentent respectivement un schéma d'un dispositif de lecture conforme à l'invention et des schémas montrant l'évolution, en fonction du temps, du potentiel de surface dans le substrat,

- la figure 4 est un diagramme fonction du temps de diverses tensions de commande appliquées sur le dispositif de lecture.

Sur les différentes figures, les mêmes repères désignent les mêmes éléments, mais pour des raisons de clarté, les cotes et proportions des divers éléments ne sont pas respectées.

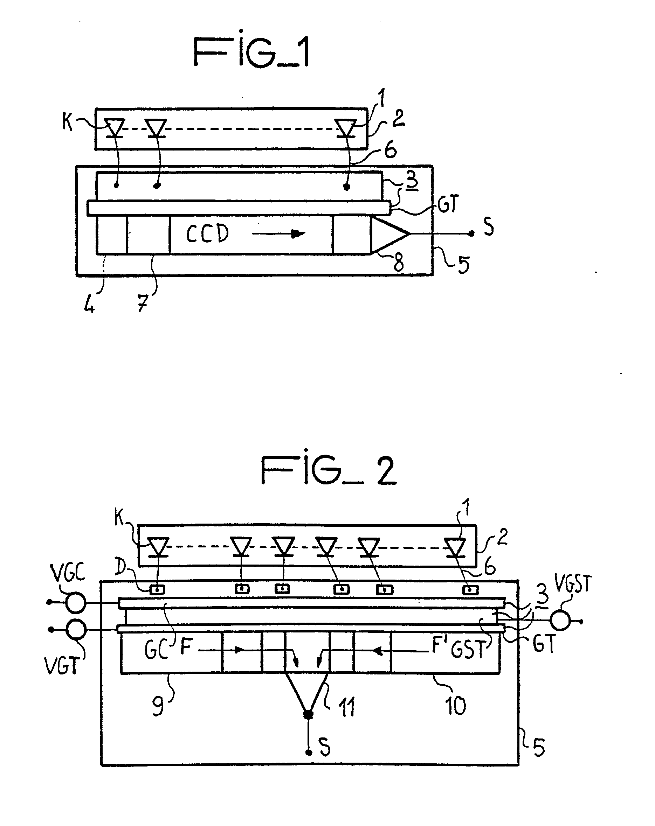

Le dispositif photosensible de l'art antérieur représenté à la figure 1 est un circuit hybride à savoir un circuit dans lequel les photosenseurs 1, qui peuvent être réalisés comme dans le mode de réalisation représenté par des photodiodes, sont intégrés sur un premier substat 2 tandis que la zone de transistion 3 et le dispositif de lecture 4 sont réalisés sur un second substrat 5. Ce type de circuits est plus particulièrement employé dans le domaine de l'infrarouge. Dans ce cas, le premier substrat 2 est de préférence réalisé en tellurure de cadmiun et de mercure, en tellurure d'étain et de plomb ou en antimoniure d'indium.

De même le substrat 5 est de préférence réalisé en silicium de type P dans le cas de photodiodes à anode commune. Toutefois il pourrait être réalisé en silicium de type N dans le cas de photodiodes à cathode commune ou en tout autre matériau semi-conducteur équivalent.

Les N photodiodes 1 sont connectées par l'intermédiaire de la zone de transition 3 à un dispositif de lecture·4 constitué principalement par un registre a décalage 7 à transfert de charge à N entrées parallèles et à une sortie série et par un étage de lecture 8. La zone de transition 3, représentée très schématiquement sur les figures 1 et 2, comporte de manière connue, N diodes D constituées par une diffusion de type N réalisée dans le substrat 5 en silicium de type P. Chaque diode D est reliée par une connexion 6 à la cathode K de la photodiode correspondante et permet d'intégrer dans le substrat 5 les charges détectées par ladite photodiode. Les diodes D sont séparées des capacités de stockage des charges réalisées sous la grille $G_{ST}$ polarisée par la tension $V_{GST}$ par une grille de commande $G_C$ reliée à une tension de polarisation $V_{GC}$. Les N capacités de stockage des charges sont connectées par l'intermédiaire d'une grille de transfert $G_T$ aux N entrées du registre à décalage 7. La grille de transfert $G_T$ est polarisée par une tension $V_{GT}$ qui est portée alternativement à un niveau haut et à un niveau bas pour réaliser simultanément et périodiquement le transfert des charges stockées dans les capacités de stockage vers les N étages du registre à décalage 7. Les charges se trouvant dans les N étages du registre 7 sont alors transférées de proche en proche vers un étage de lecture 8 situé à l'extrémité droite du registre 7 dans le mode de réalisation représenté. Avec ce type de dispositif de lecture, il est donc nécessaire d'effectuer 2 N transferts pour lire les charges détectées par les N photodiodes. Il en résulte que plus N est important, plus l'inefficacité du transfert joue sur les valeurs des charges à lire.

Conformément à la présente invention et comme représenté sur la figure 2, le dispositif de lecture n'est plus réalisé à l'aide d'un seul registre à décalage mais à l'aide de deux registres à décalage 9 et 10 à N/2 entrées parallèles et à une sortie série, la sortie de chaque registre étant reliée à l'entrée d'un étage de lecture commun 11. Les autres parties du dispositif photosensible sont semblables à celles du dispositif photosensible de la figure 1 et ne seront pas redécrites. Comme représenté sur la figure 2, les N/2 photodiodes 1 de gauche sont reliées par l'intermédiaire de la zone de transition aux N/2 entrées du registre 9 tandis que les N/2 photodiodes 1 de droite sont reliées aux N/2 entrées du registre 10. L'étage de lecture 11 qui lit alternativement les charges en sortie de chaque registre est positionné entre les deux registres 9 et 10 de sorte que les charges sont transférées de gauche à droite dans le registre 9 et de droite à gauche dans le registre 10 comme cela est indiqué par les flèches F et F'.

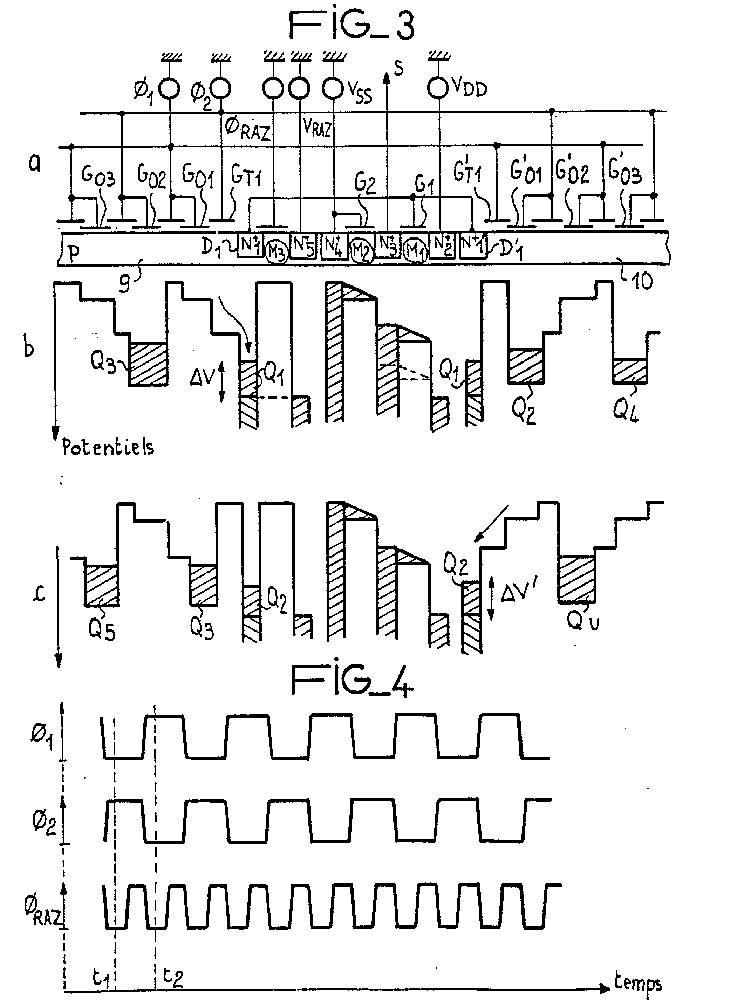

On expliquera maintenant avec référence aux figures 3(a) à (c) et à la figure 4, la structure des registres à décalage et de l'étage de lecture unique ainsi que le fonctionnement du dispositif de lecture conforme à la présente invention.

Selon le mode de réalisation représenté à la figure 3(a), les deux registres à décalage 9, 10 a transfert de charge qui sont de structure identique sont constitués par N électrodes de stockage, $G_{01}$, $G_{02}$, $G_{03}$...$G'_{01}$, $G'_{02}$, $G'_{03}$... qui sont séparées les unes des autres par des électrodes de transfert disposées, dans le mode de réalisation représenté, sur une surépaisseur d'oxyde. Les électrodes de transfert sont reliées au même potentiel que l'électrode de stockage suivante selon le sens du transfert des charges (c'est-à-dire de gauche à droite pour le registre 9 et de droite à gauche pour le registre 10). Les électrodes $G_{01}$, $G'_{02}$, $G_{03}$ sont portées au potentiel variable $\Phi_1$ et les électrodes $G_{02}$, $G'_{01}$, $G'_{03}$ sont portées au potentiel variable $\Phi_2$ qui est en opposition de phase. On remarquera que les électrodes de stockage de rang impair pour le registre 9 et les électrodes de stockage de rang pair pour le registre 10 sont portées au potentiel $\Phi_1$ et inversement pour le potentiel $\Phi_2$. Cette caractéristique permet de réaliser alternativement la lecture de chaque registre comme expliqué de manière plus détaillée ci-après.

D'autre part, on a choisi à titre d'exemple des registres à décalage à deux phases de commande avec des surépaisseurs d'oxyde pour rendre le transfert unilatéral, il est évident pour l'homme de l'art que l'invention peut s'appliquer à d'autres types de registres à décalage, en particulier à des registres à décalage à trois ou quatre phases de commande. La seule contrainte est que les charges doivent être lues alternativement en sortie d'un des registres puis de l'autre.

L'étage de lecture 11 est constitué, dans le mode de réalisation représenté, principalement par un étage suiveur formé d'un transistor MOS suiveur M1 connecté à une charge M2 réalisée par un transistor MOS à déplétion dont la grille $G_2$ est reliée à la source réalisée par une diffusion de type N référencée $N^+_4$ sur la figure 3(a), cette source étant polarisée par une tension continue $V_{SS}$. La grille $G_1$ du transistor MOS M1 est connectée a deux diodes montées en parallèles $D_1$, $D'_1$ constituées par deux diffusions de type N référencées $N^+_1$, et $N^+_1$, qui sont respectivement séparées des électrodes de stockage $G_{01}$ et $G'_{01}$ des registres 9 et 10, par des électrodes de transfert $G_{T1}$ et $G'_{T1}$ portées respectivement au potentiel $\Phi_2$ et au potentiel $\Phi_1$. La tension correspondant aux charges en entrée du transistor MOS M1 est lue sur la source de ce transistor qui est constituée par une diffusion de type N référencée $N^+_3$.

D'autre part, un transistor MOS M3 dont la grille $G_3$ est polarisée par le potentiel $\Phi_{RAZ}$, le drain est réalisé par une diffusion de type N référence $N^+_5$ connectée à une tension de polarisation $V_{RAZ}$ et la source est constituée par les diodes $D_1$, $D'_1$, est utilisé pour la remise à niveau des potentiels des diodes $D_1$, $D'_1$ une fois réalisée la lecture d'une quantité de charges.

On expliquera maintenant le fonctionnement du dispositif décrit ci-dessus avec référence aux figures 3(b), 3(c) et 4. La figure 4 représente les potentiels alternatifs $\Phi_1$, $\Phi_2$, $\Phi_{RAZ}$. Les potentiels $\Phi_1$ et $\Phi_2$ sont des tensions en créneaux en opposition de phase. La tension $\Phi_{RAZ}$ est aussi une tension en créneaux mais avec une fréquence double de celle des potentiels $\Phi_1$ et $\Phi_2$. Si l'on se place au temps $t_1$, le potentiel $\Phi_1$ est au niveau bas, le potentiel $\Phi_2$ au niveau haut et le potentiel $\Phi_{RAZ}$ au niveau bas. Il en résulte que la grille de transfert $G_{T1}$ est au niveau haut et que les charges $Q_1$ qui étaient stockées sous la grille de stockage $G_{01}$ du registre à décalage 9 ont été transférées vers les diodes $D_1$ et $D'_1$ où elles créent une variation de potentiel $\Delta V$ comme représenté sur la figure 3(b). Les diodes $D_1$ et $D'_1$ étant connectées à la grille $G_1$ du transistor MOS M1 dont le transistor MOS M2 est la charge, ont obtient la même variation de potentiel $\Delta V$ sur la grille $G_1$. Une variation representative de $\Delta V$ se retrouve aussi au niveau de la diffusion $N^+_3$ a savoir sur la sortie S. Pendant ce temps, la grille de transfert $G'_{T1}$ est au niveau bas, de ce fait les charges $Q_2$ arrivant sous la grille de stockage $G'_{01}$ du registre 10 ne peuvent pas être transférées vers les diodes $D_1$, $D'_1$. D'autre part, $\Phi_{RAZ}$ étant au niveau bas les charges $Q_1$ ne peuvent pas s'écouler vers la diffusion $N^+_5$. Une fois la lecture réalisée, $\Phi_{RAZ}$ passe au niveau haut. De ce fait le transistor MOS M3 devient passant et les charges $Q_1$ sont évacuées vers la tension de remise à niveau $V_{RAZ}$. En même temps le transistor MOS M3 effectue la précharge de l'étage de sortie comme représenté en pointillés sur la figure 3(b).

Au temps suivant $t_2$, le potentiel $\Phi_1$ est au niveau haut et le potentiel $\Phi_2$ au niveau bas. Il en résulte que la grille $G_{T1}$ du registre 9 se trouve au niveau bas et que les charges $Q_3$ arrivant sous la grille de stockage $G_{01}$ du registre 9 ne peuvent pas s'écouler vers les diodes $D_1$, $D'_1$. A l'inverse la grille $G'_{T1}$ du registre 10 se trouve au niveau haut et les charges $Q_2$ créent une variation de potentiel $\Delta V'$ au niveau des diodes $D_1$ et $D'_1$ que l'on retrouve en sortie de la même manière que décrit ci-dessus pour les charges $Q_1$.

On remarquera qu'avec le dispositif décrit ci-dessus, on obtient sur la sortie S d'abord l'information donnée par les photodiodes du centre de la barrette à la place d'obtenir les informations de droite à gauche comme dans les dispositifs de l'art antérieur. Toutefois, dans la plupart des systèmes utilisant des dispositifs photosensibles tels que décrits ci-dessus, l'information en sortie est transformée en une information numérique et stockée en mémoire.

On peut donc facilement rétablir l'ordre que l'on souhaite pour traiter les informations.

D'autre part, le mode de réalisation décrit ci-dessus concerne un circuit hybride du type de ceux utilisés dans la détection infrarouge. Il est évident pour l'homme de l'art que la présente invention peut aussi s'appliquer à des circuits monolithiques dans lesquels les photosenseurs et le dispositif de lecture sont réalisés sur le même substrat.

De plus, comme mentionné au cours de la description d'autres types de registres à décalage ainsi que d'autres types d'étages de lecture peuvent être utilisés sans sortir du cadre de la présente invention.

## Revendications

1. Un dispositif photosensible à l'état solide pour la détection d'un rayonnement électromagnétique comportant N photosenseurs (1) connectés par l'intermédiaire d'une zone de transition (3) à un dispositif de lecture (4) du type à transfert de charge, caractérisé en ce que le dispositif de lecture est séparé en deux registres à décalage (9, 10) à transfert de charge contigus et a lignés comprenant chacun N/2 entrées parallèles et une sortie série et recevant simultanément les charges détectées par les photosenseurs pour les transférer vers un étage de lecture unique (11) positionné entre les deux registres, le transfert étant réalisé sous l'action de tensions de commande choisies de manière à lire alternativement chaque registre.

2. Un dispositif photosensible selon la revendication 1, caractérisé en ce que l'étage de lecture est constitué par un étage suiveur formé d'un transistor MOS suiveur (M1) connecte à une charge (M2), deux diodes (D1, D'1) montées en parallèle et séparées chacune de la sortie d'un des registres a décalage par l'intermédiaire d'une grille de transfert ($GT_1$, $G'_{T1}$), ces diodes étant connectées à la grille du transistor MOS suiveur et par un circuit de remise à niveau des potentiels des diodes après chaque lecture.

3. Un dispositif photosensible selon la revendication 2, caractérisé en ce que les grilles de transfert ($G_{T1}$, $G'_{T1}$) sont reliées à des tensions de commande en opposition de phase.

4. Un dispositif photosensible selon l'une quelconque des revendications 1 à 3, caractérisé en ce que la zone de transition (3) est constituée par N diodes (D) reliées chacune à une photodiode et par des capacités de stockage ($G_{ST}$) séparées des diodes par une grille de commande ($G_C$) et des registres de lecture (9, 10) par une grille de transfert ($G_T$).

5. Un dispositif photosensible selon l'une quelconque des revendications 1 à 4, caractérisé en ce que, dans le cas de registres à décalage (9, 10) commandés en biphasé, les tensions de commande ($\Phi_1$, $\Phi_2$) appliquées sur les électrodes de stockage, de même rang ($G_{01}$, $G_{03}$, $G'_{01}$, $G'_{03}$ ou $G_{02}$, $G'_{02}$) sont en opposition de phase.

## Patentansprüche

1. Photoempfindliche Festkörpervorrichtung für die Erfassung einer elektromagnetischen Strahlung, mit N Photosensoren (1), die über eine Übergangszone (3) an eine Lesevorrichtung (4) vom Typ mit Ladungsüberführung angeschlossen sind, dadurch gekennzeichnet, daß die Lesevorrichtung in zwei mit Ladungsüberführung arbeitende, aneinander anschließende und miteinander ausgerichtete Schieberegister (9, 10) getrennt ist, die jeweils N/2 parallele Eingänge und einen seriellen Ausgang aufweisen sowie gleichzeitig die von den Photosensoren erfaßten Ladungen empfangen, um sie zu einer einzigen Lesestufe (11) zu überführen, die zwischen den beiden Registern angeordnet ist, wobei die Überführung unter der Wirkung von Steuerspannungen erfolgt, die so gewählt sind, daß jedes Register abwechselnd ausgelesen wird.

2. Photoempfindliche Vorrichtung nach Anspruch 1, dadurch gekennzeichnet, daß die Lesestufe durch eine Folgestufe gebildet ist, die aus einem an eine Last (M2) angeschlossenen MOS-Folgetransistor (M1), zwei parallelgeschalteten Dioden (D1, D'1), die jeweils vom Ausgang eines der Schieberegister durch ein Überführungsgate ($G_{T1}$, $G'_{T1}$) getrennt sind, wobei diese Dioden mit dem Gate des MOS-Folgetransistors verbunden sind und durch eine Schaltung gebildet ist, welche die Diodenpotentiale nach jedem Auslesen auf das Niveau zurückbringt.

3. Photoempfindliche Vorrichtung nach Anspruch 2, dadurch gekennzeichnet, daß die Überführungsgates ($G_{T1}$, $G'_{T1}$) an gegenphasige Steuerspannungen angeschlossen sind.

4. Photoempfindliche Vorrichtung nach einem der Ansprüche 1 bis 3, dadurch gekennzeichnet, daß die Übergangszone (3) durch N jeweils an eine Photodiode angeschlossene Dioden (D) und durch Speicherkapazitäten ($G_{ST}$) gebildet ist, welche von den Dioden durch ein Steuergate ($G_C$) und den Leseregistern (9, 10) durch ein Überführungsgate ($G_T$) getrennt sind.

5. Photoempfindliche Vorrichtung nach einem der Ansprüche 1 bis 4, dadurch gekennzeichnet, daß im Falle von Schieberegistern (9, 10), die doppelphasig gesteuert werden, die Steuerspannungen ($\Phi_1$, $\Phi_2$), welche an die gleichförmigen Speicherelektroden ($G_{01}$, $G_{03}$, $G'_{01}$, $G'_{03}$ oder $G_{02}$, $G'_{02}$) angelegt werden, entgegengesetzte Phasenlage aufweisen.

**Claims**

1. Photosensitive solid state device for the detection of an electromagnetic radiation, comprising N photosensors (1) connected to a reading device (4) of charge transfer type through a transition zone (3), characterized in that the reading device is separated into two contiguous and aligned charge transfer shift registers (9, 10) each comprising N/2 parallel inputs and one serial output, and simultaneously receiving the charges detected by the photosensors to transfer them to a single reading stage (11) positioned between the two registers, the transfer being performed by the action of control voltages selected in a manner to read each register alternatingly.

2. Photosensitive device according to claim 1, characterized in that the reading stage is constituted by a follower stage formed of a MOS follower transistor (M1) connected to a load (M2),two diodes (D1, D'1) mounted in parallel and each separated from the output of one of the shift registers by a transfer gate ($G_{T1}$ $G'_{T1}$), these diodes being connected to the gate of the MOS follower transistor, and of a circuit resetting to level the potentials of the diodes after each reading.

3. Photosensitive device according to claim 2, characterized in that the transfer gates ($G_{T1}$, $G'_{T1}$) are connected to control voltages having opposite phases.

4. Photosensitive device according to any of claims 1 to 3, characterized in that the transition zone (3) is constituted by N diodes (D) each connected to a photodiode and by storing capacities ($G_{ST}$) separated from the diodes by a control gate ($G_C$) and from the reading registers (9, 10) by a transfer gate ($G_T$).

5. Photosensitive device according to any of claims 1 to 4, characterized in that, in case of biphase-controlled shift registers (9,10), the control voltages ($\Phi_1$, $\Phi_2$) applied to the storing electrodes of same order ($G_{01}$, $G_{03}$, $G'_{01}$, $G'_{03}$ or $G_{02}$, $G'_{02}$) have opposite phases.

# FIG_1

# FIG_ 2

# FIG_3

Potentiels

# FIG_4